Europäisches Patentamt

European Patent Office

Office européen des brevets

(11) Publication number: **0 135 504**
**B1**

# (12) EUROPEAN PATENT SPECIFICATION

(45) Date of publication of patent specification: **24.01.90**

(21) Application number: **84900369.4**

(22) Date of filing: **15.12.83**

(86) International application number:
**PCT/US83/01997**

(87) International publication number:
**WO 84/03185 16.08.84 Gazette 84/20**

(51) Int. Cl.⁵: **H 03 K 17/10,** H 03 K 17/693

(54) **SUBSTRATE BIAS CONTROL CIRCUIT AND METHOD.**

(30) Priority: **07.02.83 US 464163**

(43) Date of publication of application:
**03.04.85 Bulletin 85/14**

(45) Publication of the grant of the patent:
**24.01.90 Bulletin 90/04**

(84) Designated Contracting States:
**DE FR GB NL**

(56) References cited:
**EP-A-0 126 184**
**US-A-3 947 727**
**US-A-4 066 918**
**US-A-4 260 909**

**IBM TECHNICAL DISCLOSURE BULLETIN, vol.
24, no. 11B, April 1982, pages 6077-6078, New
York, US; F. DELAPORTE et al.: "Substrate
connection by analog switching to most
negative power supply"**

(73) Proprietor: **MOTOROLA, INC.**
**1303 East Algonquin Road**
**Schaumburg Illinois 60196 (US)**

(72) Inventor: **HUNTINGTON, Robert, C.**
**5924 Calle del Sud**
**Phoenix, AZ 85018 (US)**

(74) Representative: **Ibbotson, Harold**
**Motorola Ltd Patent and Licensing Operations -
Europe Jays Close Viables Industrial Estate
Basingstoke Hampshire RG22 4PD (GB)**

Courier Press, Leamington Spa, England.

## Description

The present invention relates, in general, to substrate bias control circuits and methods. More particularly, the present invention relates to the aforesaid circuits and methods which are of especial utility in controlling the application of supply and substrate voltages to CMOS devices utilizing separate voltage levels therefor.

Scaled CMOS devices, those having a channel length on the order of 1.25 microns, require a reduced power supply ($V_{CC}$) for proper operation. That is, as channel lengths have decreased, a concomitantly reduced power supply voltage level is mandated in order to avoid excessive drain voltage reduction of the short channel device threshold voltage. However, such a reduced supply level (in the 3.0 volt range) prevents acceptance of more conventional 5.0 volt input logic swings when conventional CMOS input protection structures are used. It follows that with the 3.0 volt $V_{CC}$ supply connected to the N type substrate, as is conventional in CMOS technology, the use of a PN diode in the input protection circuitry would be precluded. Therefore, a novel technique for applying a 5.0 volt($V_{BB}$) substrate bias to the scaled CMOS circuit has been proposed which retains the PN diode of the input protection circuitry and still allows a 5.0 volt input logic swing to be applied thereto. A more detailed description of this technique is given in the applicant's published (28.11.84) European application EP—A—126184. However, when using a 5.0 volt substrate bias voltage and a separate 3.0 volt supply voltage for these small geometry CMOS devices, it is that the substrate voltage be applied before the supply voltage. Should the substrate not be biased before the supply voltage is applied, damage could result to the chip due to the forward biasing of the gate protection diode and the source to substrate junctions in the P channel devices. Typically, conventional CMOS structures have the substrate directly connected internally to the $V_{CC}$ supply to assure that substrate bias is applied whenever the device is powered up.

A circuit in accordance with the prior art portion of claim 1 is disclosed in IBM Technical Disclosure Bulletin Vol. 24, No. 11B, April 1982, pages 6077—6078.

It is an object of the present invention to provide an improved substrate bias control circuit and method.

It is further an object of the present invention to provide an improved substrate bias control circuit and method which allows separate circuit supply and substrate bias voltages to be applied or removed in either sequence without resultant chip damage.

## Summary of the invention

In the invention there is provided an integrated circuit including a bias voltage control circuit formed on a common substrate therewith for ensuring said substrate has a voltage applied thereto while a semiconductor device on said substrate has a supply voltage ($V_{CC}$) applied thereto including first means for coupling a bias voltage ($V_{BB}$) to said substrate when said bias voltage is present, and decoupling said bias voltage from said substrate when said bias voltage is absent; and second means for coupling said supply voltage ($V_{CC}$) to said substrate when said bias voltage ($V_{BB}$) is absent; the circuit characterized in that the semiconductor device and the first and second means include p-channel MOS transistors, in that the semiconductor device has a circuit connected to the substrate for protection against excessive voltage inputs and in that said first means decouples said bias voltage ($V_{BB}$) when said bias voltage ($V_{BB}$) is present and has a value which is less than the voltage level defined by the sum of said supply voltage ($V_{CC}$) and the absolute value of one P-channel theshold of said first means; and said second means decouples said supply voltage ($V_{CC}$) when said bias voltage ($V_{BB}$) is present and has a value which is greater than the voltage level defined by the sum of one P-channel threshold of said second means and said supply voltage ($V_{CC}$).

There is also provided a method for ensuring that an integrated circuit substrate has a voltage applied thereto while a semiconductor device on said substrate has a supply voltage ($V_{CC}$) applied thereto including the steps of providing sources of bias ($V_{BB}$) and supply ($V_{CC}$) voltages to said substrate; firstly coupling said bias voltage ($V_{BB}$) to said substrate when said bias voltage ($V_{BB}$) is present; and secondly coupling said supply voltage ($V_{CC}$) to said substrate when said bias voltage ($V_{BB}$) is absent; characterized in that the semiconductor device (10) and the sources of bias ($V_{BB}$) and supply ($V_{CC}$) voltages include p-channel MOS tranistors, in that the semiconductor device has a circuit connected to the substrate for protection against excessive voltage inputs, further characterized by decoupling said bias voltage ($V_{BB}$) from said substrate when said bias voltage is present and has a value which is less than the voltage level defined by the sum of said supply voltage ($V_{CC}$) and the absolute value of one P channel threshold voltage, and decoupling said supply voltage ($V_{CC}$) from said substrate when said bias voltage ($V_{BB}$) is present and has a value which is greater than the voltage level defined by the sum of one P-channel threshold and said supply voltage ($V_{CC}$).

## Brief description of the drawings

The above mentioned features and objects of the invention and the manner of attaining them will become more apparent by reference to the following description of an embodiment of the invention taken in conjunction with the accompanying drawings, wherein:

Fig. 1 is a simplified schematic representation of a typical input protection circuit to a CMOS inverter for use in conjunction with the present invention; and

Fig. 2 is a schematic representation of a preferred embodiment of the present invention for use in controlling the application of supply and substrate voltages to an integrated circuit.

## Description of a preferred embodiment

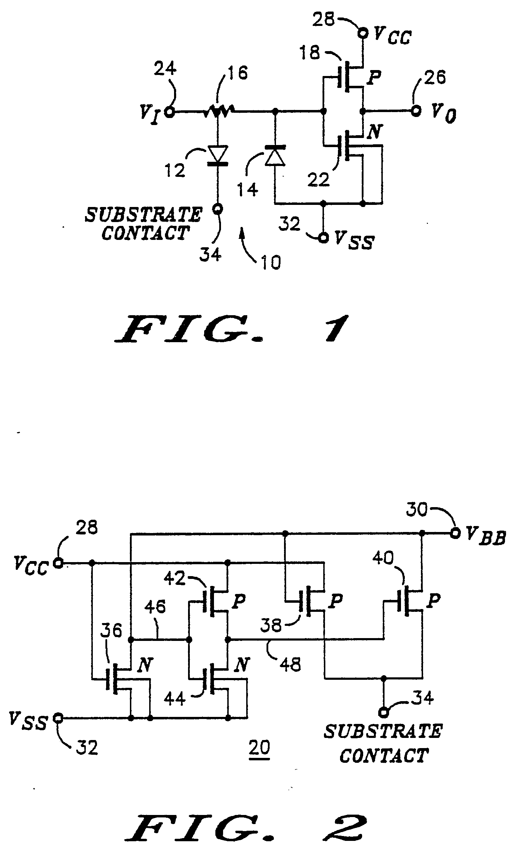

Referring now to Fig. 1, a CMOS input protection circuit 10 for use in conjunction with the present invention is shown. CMOS input protection circuit 10 comprises integrated circuitry for protecting a CMOS inverter, comprising P-channel transistor 18 and N-channel transistor 22, from excessive voltage inputs appearing on $V_I$ line 24. $V_I$ line 24 is coupled to the common connected gates of P-channel transistor 18 and N-channel transistor 22 through diffused resistor 16. A diode 12 is formed at the interface of diffused resistor 16 with the integrated circuit substrate. A source of substrate biasing voltage may be applied to the cathode of diode 12 through substrate contact 34. In a conventional CMOS input protection circuit, substrate contact 34 would be connected to a source of supply voltage ($V_{cc}$). However, substrate contact 34 may also be connected to a source of substrate bias voltage ($V_{BB}$) as disclosed in EP—A—126184. In this latter instance, substrate contact 34 may comprise an N+ diffusion within an N type substrate.

An additional diode 14, having its cathode connected to the gates of P-channel transistor 18 and N-channel transistor 22, couples these gates to $V_{ss}$ line 32. In general, $V_{ss}$ line 32 is held at a ground potential with respect to $V_{cc}$ and $V_{BB}$. A source of supply voltage ($V_{cc}$) is applied to the source of P-channel transistor 18, which has its drain connected to the drain of N-channel transistor 22. The source and P type well in which N channel transistor 22 is formed is connected to $V_{ss}$ line 32. An output signal appearing at the common connected drains of P channel transistor 18 and N channel transistor 22 is applied to $V_0$ line 26.

In the utilization of CMOS input protection circuit 10, with substrate contact 34 connected to a source of $V_{BB}$ of 5.0 Volts, it can be seen that an input signal on $V_I$ line 24 can't go more positive than one diode drop above the level of 5.0 volts without turning on diode 12. Thus, a five-volt input swing appearing on $V_I$ line 24 can be applied to the inverter comprising P channel transistor 18 and N channel transistor 22 even with a $V_{cc}$ level of 3.0 volts, as is the case when utilizing scaled CMOS circuitry. However, it is necessary that the voltage applied to substrate contact 34 be applied before the supply voltage $V_{cc}$. In conventional CMOS technology this is accomplished by supplying $V_{cc}$ to substrate contact 34 in order to bias the substrate. Should the supply voltage $V_{cc}$ be applied before a biasing voltage is applied to substrate contact 34, damage will result to the integrated circuit resulting from forward biasing gate protection diode 12 as well as the source to substrate junctions of the P channel transistors such as P channel transistor 18.

Referring additionally now to Fig. 2, a substrate bias voltage control circuit 20 for controlling application of a bias voltage to substrate contact 34 is shown. Substrate bias voltage control circuit 20 independently couples a source of substrate bias voltage ($V_{BB}$) as well as a source of supply voltage ($V_{cc}$) to substrate contact 34. As illustrated, an N channel transistor 36 has its source contact connected to $V_{ss}$ line 32 and its drain contact connected to $V_{BB}$ line 30. The gate electrode of N channel transistor 36 is connected to $V_{cc}$ line 28. The drain contact of N channel transistor 36 defines a node 46. It will be noted that node 46 is electrically common with $V_{BB}$ line 30 but will be referred to as node 46 for purposes of clarity.

Signals appearing on node 46 are applied to the input of a conventional CMOS inverter comprising P channel transistor 42 in series with N channel transistor 44. This inverter is supplied by $V_{cc}$ line 28 with respect to ground which is $V_{ss}$ line 32. The output appearing at the common connected drains of P channel tranistor 42 and N channel transistor 44 is applied to node 48 and connected to the gate of P channel transistor 40. P channel transistor 40 has its source connected to $V_{BB}$ line 30 and its drain connected to substrate contact 34. The drain of P channel transistor 38 is also connected to substrate contact 34 and has its source contact connected to $V_{cc}$ line 28. The gate of P channel transistor 38 is connected to $V_{BB}$ line 30.

## $V_{cc}$ only and $V_{ss}$ are applied

In operation, 3.0 volts is applied to $V_{cc}$ line 28, the inverter comprising P channel transistor 42 and N channel transistor 44, and the gate of N channel transistor 36. This causes the channel of N channel transistor 36 to invert which grounds the device gates connected to node 46. As a result, P channel transistor 38 conducts and connects the 3.0 volts appearing on $V_{cc}$ line 28 to substrate contact 34, and P channel transistor 42 conducts which raises node 48 to 3.0 volts which holds P channel transistor 40 off. The chip now can function with its substrate bias equal to the 3.0 volts appearing on $V_{cc}$ line 28 and will perform satisfactorily providing a logic swing appearing on $V_I$ line 24 does not exceed 3.0 volts in amplitude.

## $V_{cc}$ and $V_{BB}$ and $V_{ss}$ are applied

If 5.0 volts is then applied to $V_{BB}$ line 30, node 46 is raised to 5.0 volts which turns P-channel transistors 38 and 42 off and turns N-channel transistor 44 on to drive node 48 to ground, or $V_{ss}$. This causes P-channel transistor 40 to conduct and connects 5.0 volts to substrate contact 34. Note that N-channel transistor 36 continues to conduct with $V_{DS}$ equal to 5.0 volts, but N-channel transistor 36 is designed with a very long and narrow channel (a very low Z/L ratio) and will dissipate a predetermined very low current. The two voltage supplies $V_{cc}$ and $V_{BB}$ are effectively decoupled by holding the gate of P-channel transistor 38 at the higher voltage to hold the device in nonconduction.

The transient switching between substrate voltage control from $V_{cc}$ to $V_{BB}$ may be considered as that condition when $V_{cc}$ is held at a constant 3.0 volts and $V_{BB}$ is ramped from 0 to 5.0 volts. This condition occurs when the $V_{BB}$ supply is turned on while the $V_{CC}$ supply is on. As long as $V_{BB} < V_{TN}$, where $V_{TN}$ is the threshold voltage of the N-channel transistors and N channel transistor 44 is off. When

$$V_{TN} < V_{BB} < (V_{CC} + V_{TP})$$

$V_{TP}$ being the threshold voltage of the P-channel transistors, both P-channel transistor 42 and N channel transistor 44 are on and act as a voltage divider. Because of the relative values of their Z/L ratios, Node 48 is held close to $V_{CC}$, which holds P-channel transistor 40 off, while P channel transistor 38 remains on. When $V_{BB} > (V_{CC} + V_{TP})$, both P-channel transistors 38 and 42 are off, node 48 goes to ground, P-channel transistor 40 is turned on, and the substrate voltage is determined by $V_{BB}$. At the instant $V_{BB}$ exceeds $(V_{CC} + V_{TO})$, P-channel tranistor 42 and N-channel transistor 44 effectively change from a voltage divider to an inverter, and control of the substrate voltage is switched from $V_{CC}$ to $V_{BB}$.

From the above, it can be seen that the Z/L ratios of P-channel transistor 42 and N channel transistor 44 must have widely different values. The Z/L ratios for P-channel transistors 38 and 40 should provide an acceptably low channel voltage drop under conditions of maximum anticipated substrate current. (450/1.25 has been found to be satisfactory). The Z/L ratios for N channel transistors 36 and 44 will provide acceptably low current dissipation at approximately 6/80. Layout is simplified by using the same Z/L ratio for P channel transistor 42 as that for P channel transistors 38 and 40.

$V_{BB}$ only and $V_{SS}$ are applied

5.0 volts is applied to the gate of N channel transistor 44 which causes its channel to invert thereby grounding node 48. This causes P channel transistor 40 to conduct and connects 5.0 volts to substrate contact 34. With 5.0 volts on its gate, P channel transistor 38 is held off, which decouples the 5.0 volts from the remainder of the circuit.

If 3.0 volts is then applied to $V_{CC}$ line 28, node 46 and node 48 voltages are unchanged and the states of P channel transistor 38 and P channel transistor 40 remain as they were prior to the application of the 3.0 volts. However, N channel transistor 36 is turned on and conducts a very low current as previously described. Again, P channel transistor 38 is held off with 5.0 volts on its gate to isolate the two applied voltages from each other.

$V_{CC}$ and $V_{BB}$ (no $V_{SS}$) are applied

In this case, with no $V_{SS}$, node 48 voltage is indeterminate. However, no matter what voltage node 48 might assume, P channel transistor 48 will continue to be held off because its gate is held at the higher of the two applied voltages, i.e. $V_{BB}$. This will assure isolation of the two voltages from each other.

If $V_{SS}$ is then applied, normal operation will occur as described previously.

P channel transistor 38 and P channel transistor 40 are designed with very large Z/L ratios in order that their source-to-drain voltage drop (operating in the linear region) will be negligibly small for maximum anticipated substrate current. As described previously, the designed Z/L ratio for N channel transistor 36 will be sufficiently small to hold the drain current in this device to an acceptably low value.

It should be noted, that the 3.0 volt $V_{CC}$ and 5.0 volt $V_{BB}$ values are given only as an example, because, within voltage limitations of the transistors themselves, this circuit will function with any two voltages. It should be noted, that in normal usage the substrate bias voltage will never be less than the supply voltage under steady-state conditions.

What has been provided therefore is an improved substrate bias control circuit and method which allows separate circuit supply and substrate bias voltages to be applied or removed in either sequence without resulting chip damage. The circuit and method of the present invention allows for an integrated circuit chip operation on the circuit supply voltage only, in the absence of a substrate bias voltage, by connecting the substrate to the supply voltage until substrate voltage is applied. The circuit and method of the present invention further allow for isolation between sources of circuit supply and substrate bias voltage supply. Still further, the improved substrate bias control circuit and method of the present invention are simply implemented requiring only nominal on-chip area while concomitantly dissipating very little circuit power.

While there have been described above the principles of this invention in conjunction with specific apparatus, it is to be clearly understood that this description is made only by way of example and not as a limitation to the scope of the invention.

**Claims**

1. An integrated circuit including a bias voltage control circuit (20) formed on a common substrate therewith for ensuring said substrate has a voltage applied thereto while a semiconductor device (10) on said substrate has a supply voltage ($V_{CC}$) applied thereto including first means (40) for coupling a bias voltage ($V_{BB}$) to said substrate when said bias voltage is present, and decoupling said bias voltage from said substrate when said bias voltage is absent; and second means (38) for coupling said supply voltage ($V_{CC}$) to said substrate when said bias voltage ($V_{BB}$) is absent; the circuit characterized in that the semiconductor device (10) and the first and second means (40, 38) include p-channel MOS transistors, in that the semiconductor device has a circuit (12) connected to the substrate (34) for protection against excessive voltage inputs and in that said first means (40) decouples said bias voltage ($V_{BB}$) when said bias voltage ($V_{BB}$) is present and has a value which is less than the voltage level defined by the sum of said supply voltage ($V_{CC}$) and the absolute value of one P-channel threshold of said first means (40); and said second msans (38) decouples said supply voltage ($V_{CC}$) when said bias voltage ($V_{BB}$) is present and has a value which is greater than the voltage level defined by the sum of one P-channel threshold of said second means (38) and said supply voltage ($V_{CC}$).

2. The circuit of claim 1 and further comprising third means (36) coupling said substrate bias voltage ($V_{BB}$) to a circuit ground ($V_{SS}$), said third means having a first input thereof connected to said supply voltage ($V_{CC}$), and inverter means (42, 44) connected between said supply voltage ($V_{CC}$) and said circuit ground ($V_{SS}$), said inverter means having an input node thereof connected to said substrate bias voltage ($V_{BB}$) and having an output node (48) coupled to an input of said first switching means (40).

3. The circuit of claim 2 wherein said third (36) means comprise MOS transistors.

4. The circuit of claim 3 wherein said third switching means (36) comprises an N-channel device, and said inverter means (42, 44) comprises a CMOS inverter.

5. A method for ensuring that an integrated circuit substrate has a voltage applied thereto while a semiconductor device on said substrate has a supply voltage ($V_{CC}$) applied thereto including the steps of providing sources of bias ($V_{BB}$) and supply ($V_{CC}$) voltages to said substrate; firstly coupling said bias voltage ($V_{BB}$) to said substrate when said bias voltage ($V_{BB}$) is present; and secondly coupling said supply voltage ($V_{CC}$) to said substrate when said bias voltage ($V_{BB}$) is absent; characterized in that the semiconductor device (10) and the sources of bias ($V_{BB}$) and supply ($V_{CC}$) voltages include p-channel MOS transistors, in that the semiconductor device has a circuit connected to the substrate for protection against excessive voltage inputs, further characterized by decoupling said bias voltage ($V_{BB}$) from said substrate when said bias voltage is present and has a value which is less than the voltage level defined by the sum of said supply voltage ($V_{CC}$) and the absolute value of one P channel threshold voltage, and decoupling said supply voltage ($V_{CC}$) from said substrate when said bias voltage ($V_{BB}$) is present and has a value which is greater than the voltage level defined by the sum of one P-channel threshold and said supply voltage ($V_{CC}$).

**Patentansprüche**

1. Integrierte Schaltung mit einer auf einer gemeinsamen Unterlage ausgebildeten Vorspannungs-Steuerschaltung (20), um das Anliegen einer Spannung an der Unterlage sicherzustellen, während an einer auf der Unterlage befindlichen Halbleiter-Vorrichtung (10) eine Versorgungsspannung ($V_{CC}$) angeschlossen ist, mit einem ersten Hilfsmittel (40) zum Anschließen einer Vorspannung ($V_{BB}$) an die Unterlage in Gegenwart der Vorspannung und zum Abrennen der Vorspannung von der Unterlage beim Fehlen der Vorspannung und mit einem zweiten Hilfsmittel (38) zum Anschließen der Versorgungsspannung ($V_{CC}$) an die Unterlage beim Fehlen der Vorspannung ($V_{BB}$), dadurch gekennzeichnet, daß die Halbleiter-Vorrichtung (10) und die beiden Hilfsmittel (40, 38) MOS-Transistoren mit p-Kanal enthalten bzw. sind, daß die Halbleiter-Vorrichtung eine mit der Unterlage (34) verbundene Schaltung (12) zum Schutz vor übermäßigen Eingangsspannungen aufweist, und daß das erste Hilfsmittel (40) die Vorspannung ($V_{BB}$) abtrennt, sobald diese ($V_{BB}$) bei einem Wert vorhanden ist, der niedriger als die Spannungsgröße ist, die von der Summe aus der Versorgungsspannung ($V_{CC}$) und dem absoluten Wert eines p-Kanal-Schwellenwertes des ersten Hilfsmittels (40) festgelegt ist, und das zweite Hilfsmittel (38) die Versorgungsspannung ($V_{CC}$) abtrennt, sobald die Vorspannung ($V_{BB}$) mit einem Wert vorhanden ist, der größer als die Spannungsgröße ist, die von der Summe aus einem p-Kanal-Schwellenwert des zweiten Hilfsmittels (38) und der Versorgungsspannung ($V_{CC}$) festgelgt ist.

2. Schaltung des Anspruches 1, die ferner ein drittes Hilfsmittel (36) zum Anschließen der Vorspannung ($V_{BB}$) der Unterlage an eine Erdungsschaltung ($V_{SS}$) enthält, wobei die erste Eingangsklemme des dritten Hilfsmittels mit der Versorgungsspannung ($V_{CC}$) verbunden ist, und bei der Negatoren (42, 44) zwischen der Versorgungsspannung ($V_{CC}$) und der Erdungsschaltung ($V_{SS}$) liegen und mit ihrem Eingangspunkt an der Vorspannung ($V_{BB}$) der Unterlage und mit ihrem Ausgangspunkt (48) an dem Eingang des ersten Schaltungshilfsmittels (40) angeschlossen sind.

3. Schaltung des Anspruches 2, bei der das dritte Hilfsmittel (36) MOS-Transistoren enthält.

4. Schaltung des Anspruches 3, bei der das dritte Schaltungshilfsmittel (36) eine n-Kanalvorrichtung enthält und die Negatoren (42, 44) einen CMOS-Negator enthalten.

5. Verfahren zur Sicherstellung, daß an der Unterlage einer integrierten Schaltung eine Spannung anliegt, während an einer auf der Unterlage befindlichen Halbleiter-Vorrichtung eine Versorgungsspannung ($V_{CC}$) angelegt ist, mit den Arbeitsschritten, für die Unterlage Quellen der Vorspannung ($V_{BB}$) und der Versorgungsspannung ($V_{CC}$) vorzusehen, erstens in Gegenwart der Vorspannung ($V_{BB}$) diese ($V_{BB}$) an die Unterlage anzuschließen und zweitens bei einem Ausbleiben der Vorspannung ($V_{BB}$) die Versorgungsspannung ($V_{CC}$) an die Unterlage anzuschließen, dadurch gekennzeichnet, daß die Halbleiter-Vorrichtung (10) und die Quellen der Vorspannung ($V_{BB}$) und der Versorgungsspannung ($V_{CC}$) MOS-Transistoren mit einem p-Kanal enthalten, daß die Halbleiter-Vorrichtung eine mit der Unterlage verbundene Schaltung zum Schutz gegen übermäßige Eingangsspannungen aufweist, ferner dadurch gekennzeichnet, daß die Vorspannung ($V_{BB}$) von der Unterlage abgetrennt wird, wenn sie mit einem Wert vorhanden ist, der geringer als die Spannungsgröße ist, die von der Summe aus der Versorgungsspannung ($V_{CC}$) und dem absoluten Wert einer p-Kanal-Schwellenwertspannung festgelegt ist, und daß die Versorgungsspannung ($V_{CC}$) von der Unterlage abgetrennt wird, wenn die Vorspannung ($V_{BB}$) mit einem Wert vorhanden ist, der größer als die Spannungsgröße ist, die von der Summe aus einem p-Kanal-Schwellenwert und der Versorgungsspannung ($V_{CC}$) festgelegt ist.

## Revendications

1. Circuit intégré incluant un circuit de contrôle de tension de polarisation (20) formé sur un substrat commun avec celuici pour garantir qu'une tension est appliquée au substrat tandis qu'un tension d'alientation ($V_{CC}$) est appliquée à un dispositif à semiconducteur (10) sur le substrat, incluant un premier moyen (40) pour appliquer une tension de polarisation ($V_{BB}$) au substrat quand la tension de polarisation est présente, et pour supprimer l'application de la tension de polarisation au substrat quand la tension de polarisation est absente; et un deuxième moyen (38) pour appliquer la tension d'alimentation ($V_{CC}$) au substrat quand la tension de polarisation ($V_{BB}$) est absente; le circuit étant caractérisé en ce que le dispositif à semiconducteur (10) et les premier et deuxième moyens (40, 38) comprennent des transistors à métal-oxyde-semiconducteur MOS à canal P, en ce que le dispositif à semiconducteur comporte un circuit (12) connecté au substrat (34) pour le protéger contre des tensions d'entrée excessives et en ce que le premier moyen (40) supprime l'application de la tension de polarisation ($V_{BB}$) quand la tension de polarisation ($V_{BB}$) est présente et a une valeur qui est inférieure au niveau de tension défini par la somme de la tension d'alimentation ($V_{CC}$) et de la valeur absolue d'un seuil de canal P du premier moyen (40); et le deuxième moyen (38) supprime l'application de la tension d'alimentation ($V_{CC}$) quand la tension de polarisation ($V_{BB}$) est présente et a une valeur qui est supérieure au niveau de tension défini par la somme d'un seuil de canal P du deuxième moyen (38) et de la tension d'alimentation ($V_{CC}$).

2. Circuit selon la revendication 1, comprenant en outre un troisième moyen (36) reliant la source de tension de polarisation de substrat ($V_{BB}$) à la masse de circuit ($V_{SS}$), le troisième moyen ayant une entrée connectée pour recevoir la tension d'alimentation ($V_{CC}$), et un moyen inverseur (42, 44) connecté entre la source de tension d'alimentation ($V_{CC}$) et la masse de circuit ($V_{SS}$), le moyen inverseur ayant un noeud d'entrée connecté à la source de tension de polarisation de substrat ($V_{BB}$) et un noeud de sortie (48) couplé à une entrée du premier moyen de commutation (40).

3. Circuit selon la revendication 2, dans lequel le troisième moyen (36) comprend des transistors MOS.

4. Circuit selon la revendication 3, dans lequel le troisième moyen de commutation (36) comprend un dispositif à canal N, et le moyen inverseur (42, 44) comprend un inverseur à métal-oxyde-semiconducteur à symétrie complémentaire CMOS.

5. Procédé pour garantir qu'une tension est appliquée à un substrat de circuit intégré tandis qu'une tension d'alimentation ($V_{CC}$) est appliquée à un dispositif à semiconducteur sur le substrat, incluant les opérations consistant à fournir des sources de tension de polarisation ($V_{BB}$) et de tension d'alimentation ($V_{CC}$) au substrat; premièrement, à appliquer la tension de polarisation ($V_{BB}$) au substrat quand la tension de polarisation ($V_{BB}$) est présente; et, deuxièmement, à appliquer la tension d'alimentation ($V_{CC}$) au substrat quand la tension de polarisation ($V_{BB}$) est absente; caractérisé en ce que le dispositif à semiconducteur (10) et les sources de tension de polarisation ($V_{BB}$) et de tension d'alimentation ($V_{CC}$) comprennent des transistors à métal-oxyde-semiconducteur MOS à canal P, en ce que le dispositif à semiconducteur comporte un circuit connecté au substrat pour le protéger contre des tensions d'entrée excessives, caractérisé en outre en ce qu'il consiste à supprimer l'application de la tension de polarisation ($V_{BB}$) au substrat quand la tension de polarisation est présente et a une valeur qui est inférieure au niveau de tension défini par la somme de la tension d'alimentation ($V_{CC}$) et de la valeur absolue d'une tension de seuil de canal P, et à supprimer l'application de la tension d'alimentation ($V_{CC}$) au substrat quand la tension de polarisation ($V_{BB}$) est présente et a une valeur que est supérieure au niveau de tension défini par la somme d'un seuil de canal P et de la tension d'alimentation ($V_{CC}$).

*FIG. 1*

*FIG. 2*